# EUROPEAN PATENT APPLICATION

(11) **EP 2 690 672 A1**
(43) Date of publication of application: **29.01.2014**
(21) Application number: 12761510.2
(22) Date of filing: 23.03.2012
(51) Int. Cl.: H01L 31/042

(54) **SOLAR CELL PANEL, SOLAR CELL MODULE AND METHOD FOR PRODUCING SOLAR CELL MODULE**

(30) Priority: 24.03.2011 JP 2011066601
(71) Applicant: Sanyo Electric Co., Ltd., Osaka 570-8677 (JP)
(72) Inventor: ENDO Osamu, Moriguchi-shi Osaka 570-8677 (JP)
(74) Representative: Glawe, Delfs, Moll
(86) International application number: PCT/JP2012/057449
(87) International publication number: WO 2012/128342

(57) **Abstract**

The present invention provides a solar cell module in which the frame is easily assembled, and in which cracking and chipping of protective members used on the front surface side and back surface side of a solar cell panel can be prevented. The present invention is a solar cell module including a solar cell panel (10) having a plurality of solar cells (11) sealed between a first protective member (12) and a second protective member (13), and a frame (20) mounted on the periphery of the solar cell panel (10). Machined surfaces (12c, 13c) that have been chamfered are provided on the edges of the first protective member (12) and the second protective member (13), respectively, and the machined surface (12c) formed on the first protective member (12) is larger than the machined surface (13c) provided on the second protective member (13).

## Description

### CROSS-REFERENCE TO RELATED APPLICATIONS

This is a continuation of International Application PCT/JP2012/057449, with an international filing date of March 23, 2012, filed by applicant, the disclosure of which is hereby incorporated by reference in its entirety.

### FIELD OF THE INVENTION

The present invention relates to a solar cell panel, a solar cell module, and a manufacturing method for a solar cell module. The present invention relates more specifically to a solar cell module provided with a frame.

### BACKGROUND OF THE INVENTION

Solar cell modules, which convert sunlight to electricity to output electric power, are widely used. In order to resist various environmental impacts such as the weight of snow and wind pressure, solar cell modules have a frame formed from a metal such as aluminum on the peripheral edge of the solar cell panel containing the solar cells.

Because the strength of the solar cell module is ensured not just by the surface members but also the frame, the surface members of even a large solar cell module do not have to be very thick. This prevents an increase in weight and makes the panels easier to handle. Also, because more light passes through thinner surface members, photoelectric conversion efficiency can be improved.

In these solar cell modules, a sealing material is interposed between the solar cell panel and the frame, and the solar cell panel is fitted into and secured inside the frame. Sealing materials with many different shapes, materials, and mounting methods have been proposed.

A bifacial light-receiving solar cell module has been disclosed in Laid-Open Patent Publication No. 2007-95819 (Patent Document 1) in which the holding portion of the frame is filled with a sealing material such as a silicone resin, and the solar cell panel is fitted into the frame to place the sealing material between the frame and the solar cell panel.

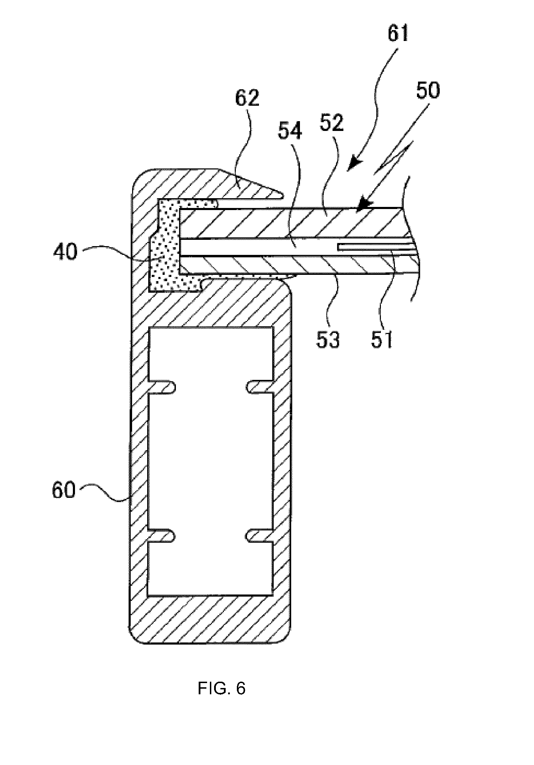

FIG. 6 is a cross-sectional view showing the main portion of a solar cell module of the prior art. As shown in FIG. 6, the solar cells 51 are interposed using a transparent first protective member 52 on the side with the front surface (light-receiving surface) and a transparent second protective member 53 on the side with the back surface, and the space inside is filled with a transparent resin 54 to complete the solar cell panel 50. An aluminum frame 60 is then fitted onto the peripheral edges of the solar cell panel 50 via a sealing material 40 to complete the solar cell module 61.

### Cited Documents

### Patent Documents

Patent Document 1: Laid-Open Patent Publication No. 2007-95819

### SUMMARY OF THE INVENTION

### Problem Solved by the Invention

However, a solar panel in a solar cell module with a large surface area is subject to great deflection and deformation. When the solar cell panel is fitted into the frame, the deformations cause the first protective member or second protective member rubs against the end portion of the frame, and the first protective member or second protective member may become scratched. When the first protective member 1 or second protective member 2 is a glass plate, the end portion of the first protective member or second protective member comes into contact with the frame when the solar cell panel is fitted into the frame, and the glass plate may become chipped or cracked. Therefore, great care must be exercised against deflection etc. when inserting the solar cell panel into the frame.

### Means of Solving the Problem

The present invention is a solar cell module including a solar cell panel having a plurality of solar cells sealed between a first protective member and a second protective member, and a frame mounted on the periphery of the solar cell panel. In this solar cell module, an edge of each of the first protective member and the second protective member has been chamfered, and the surface of the first protective member formed by chamfering is different in size from the surface of the second protective member formed by chamfering.

The present invention also includes a solar cell panel having a plurality of solar cells sealed between a first protective member and a second protective member, and a frame mounted on the periphery of the solar cell panel. An edge of each of the first protective member and the second protective member has been chamfered, the surface of the first protective member formed by chamfering is different in size from the surface of the second protective member formed by chamfering, and the first protective member and the second protective member are positioned when the solar cell panel is fitted into the frame such that the protective member having the larger surface formed by chamfering is positioned on the bottom side in the vertical direction.

The present invention is also a solar cell panel having a plurality of solar cells sealed between a first protective member and a second protective member, the periphery thereof being fitted into and secured inside a recessed portion. In this solar cell panel, an edge of each of the first protective member and the second protective member has been chamfered, and the surface of the first protective member formed by chamfering is different in size from the surface of the second protective member formed by chamfering.

### Effect of the Invention

The present invention is able to provide a solar cell module in which the solar cell panel can be easily mounted.

### BRIEF DESCRIPTION OF THE DRAWINGS

FIG. 1 is a simplified cross-sectional view showing the main portion of the solar cell module in an embodiment of the present invention.
FIG. 2 is a simplified cross-sectional view showing the solar cell panel fitted into the frame.
FIG. 3 is an enlarged cross-sectional view showing the main portion of the solar cell module in the embodiment of the present invention.
FIG. 4 is a perspective view showing a solar cell module according to the embodiment of the present invention.
FIG. 5 is a plan view showing a solar cell module according to the embodiment of the present invention.
FIG. 6 is a cross-sectional view showing the main portion of a solar cell module of the prior art.

### DETAILED DESCRIPTION OF THE INVENTION

The following is a detailed explanation of an embodiment of the present invention with reference to the drawings. Identical or similar components in the drawings are denoted by the same reference signs and repeated explanation of these components has been omitted in order to avoid redundancy.

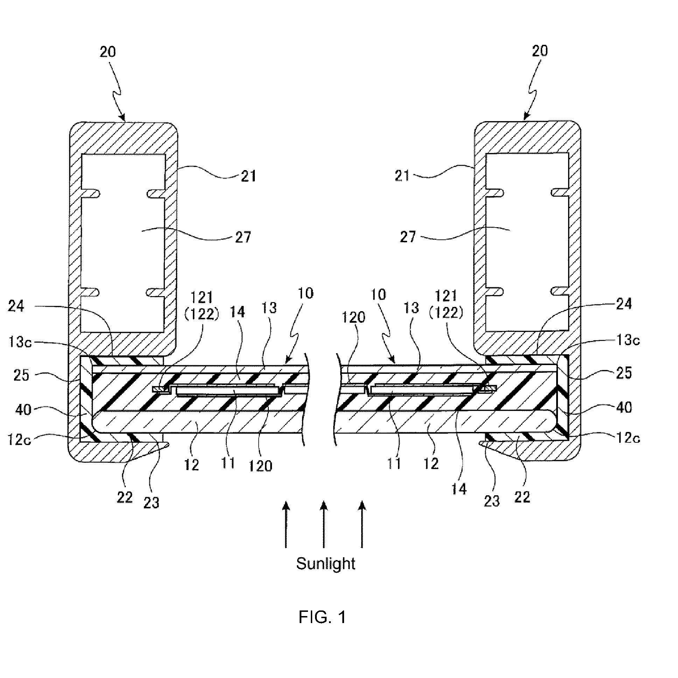

The following is an explanation of an embodiment of the present invention with reference to FIG. 1 through FIG. 5. In the solar cell module 1 according to the present embodiment, a frame 20 is mounted on the peripheral edges of a solar cell panel 10 containing a plurality of solar cells 11.

In the present embodiment, the solar cells 11 use a substantially square single-crystal silicon semiconductor having an approximate thickness of 0.15 mm and sides of approximately 100 mm as a substrate. The solar cells 11 are constituted using an n-type single-crystal silicon substrate semiconductor on which a p-type amorphous silicon layer has been laminated. More specifically, in the solar cells 11, a substantially intrinsic amorphous silicon layer is interposed between the n-type single-crystal silicon substrate and the p-type amorphous silicon layer in order to provide a structure with fewer defects in the heterojunction interface and with improved characteristics.

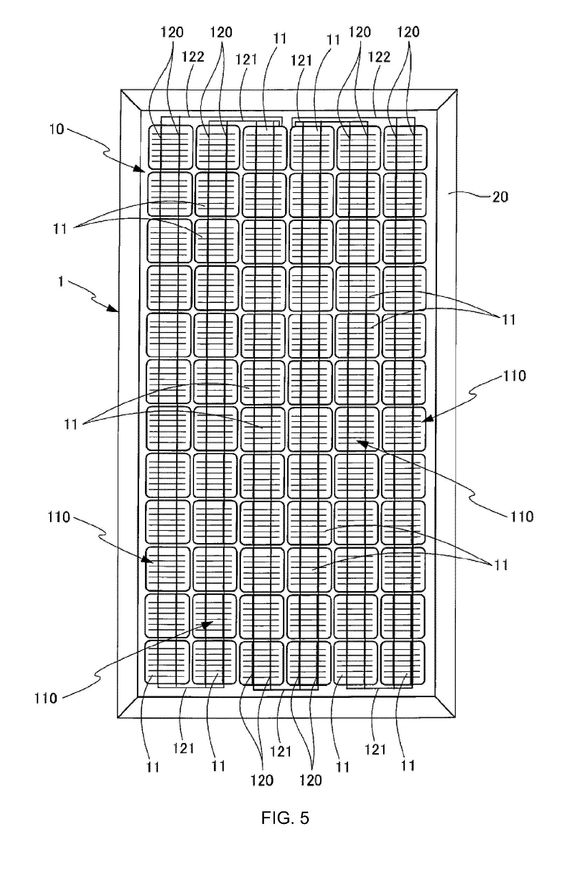

As shown in FIG. 1 and FIG. 5, each solar cell 11 is connected electrically to the adjacent solar cells 11 using a wiring member 120 made of a conductive material such as flat copper foil. In other words, one end of the wiring member 120 is connected to an electrode on one solar cell 11, and the other end is connected to an electrode on another adjacent solar cell 11. A plurality of solar cells 11 arranged in a predetermined direction are connected electrically by means of wiring material 120 to form a single string 110. Connection wiring 121 used to connect the strings 110, and lead wire 122 for outputting power are connected to the strings 110 in order to configure the solar cell module 1 to output a predetermined amount of power.

A plurality of solar cells 11 connected electrically by wiring members 120 are arranged between the first protective member 12 on the side with the front surface and the second protective member 13 on the side with the back surface, and sealed using a transparent sealing material 14 such as ethylene-vinyl acetate (EVA), which has superior weather resistance and moisture resistance, to form a solar cell panel 10. The first protective member 12 and the second protective member 13 are made of a transparent material such as glass or plastic. In the present embodiment, the protective members are glass plates.

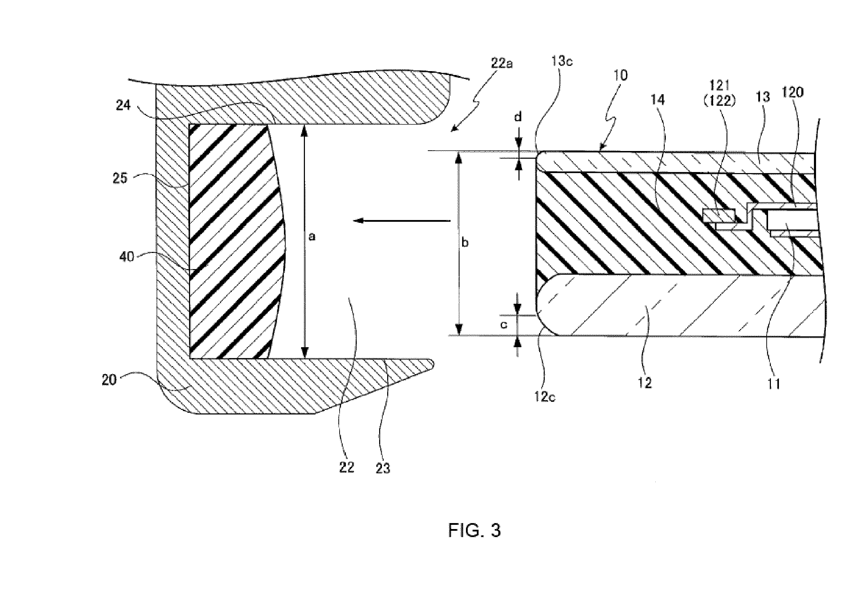

In the present invention, as shown in FIG. 3, the first protective member 12 positioned on the side with the front surface and the second protective member 13 positioned on the side with the back surface have different thicknesses, and the second protective member 13 on the side with the back surface is the thinner member.

The edges of the first protective member 12 and the second protective member 13 are chamfered, and the size of the chamfering on the first protective member 12 and the second protective member 13 is different. In other words, machined surfaces 12c and 13c, which are curved surfaces produced by the chamfering, are formed in the end portions of the first protective member 12 and the second protective member 13, respectively. The curvature of the curved surface formed as the machined surface 12c in the first protective member 12 is different from the curvature of the curved surface formed as the machined surface 13c in the second protective member 13, and the radius of curvature of the machined surface 12c is greater than the radius of curvature of the machined surface 13c.

The peripheral edges of the solar cell panel 10 are inserted into a frame 20 made of a metal such as aluminum using a sealing material 40. The frame 20 is formed using aluminum, stainless steel or steel plate roll-forming. If necessary, a terminal box (not shown) is provided, for example, on the surface of the second protective member 13 on the side with the back surface.

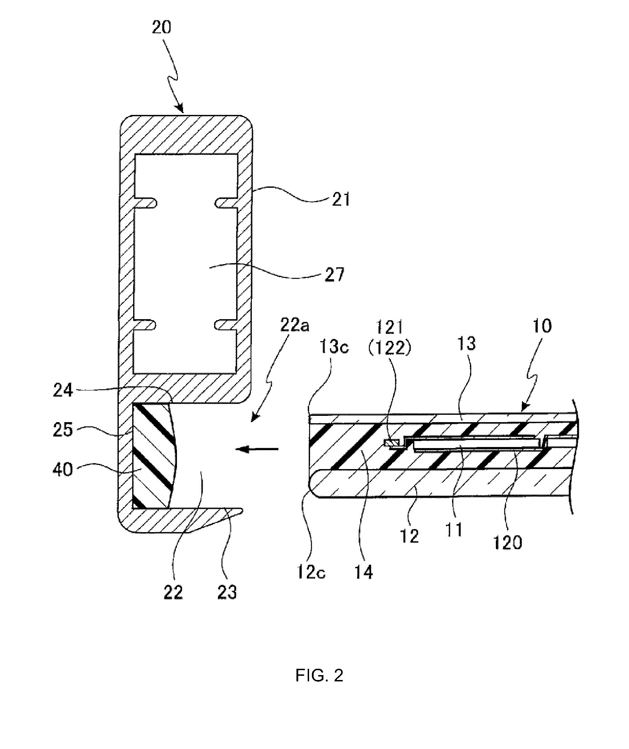

The example of a frame 20 shown in FIG. 2 and FIG. 3 has a main portion 21 with a hollow structure, and a substantially U-shaped fitting portion 22, positioned on the side of the main portion 21 with the light-receiving surface, for accepting and fitting, via a sealing material, the peripheral portions of the solar cell panel 10.

The fitting portion 22 includes an open portion 22a into which the peripheral portions of the solar cell panel 10 are inserted, an upper surface portion 23 facing the first protective member 12 arranged on the side of the solar cell panel 10 with the front surface, a lower surface portion 24 facing the second protective member 13 arranged on the side of the solar cell panel 10 with the back surface, and a side surface portion 25 facing the sealing material 14 exposed from the first protective member 12 and the second protective member 13. A bent surface may be formed on either or both the side surface portion 25 and the lower surface portion 24, in the portion where the side surface portion 25 and lower surface portion 24 of the fitting portion 22 are connected, and the bent surface may serve as a recessed portion for holding the sealing material.

As shown in FIG. 3, the height (a) of the open portion 22a of the fitting portion 22 is slightly greater than the corresponding cross-sectional height (b) of the peripheral portion of the solar cell panel 10. This height (a) is established so that the first protective member 12 on the front surface side of the solar cell panel 10 and the second protective member 13 on the back surface side do not rub together. The edges positioned at the front end of the open portion 22a and facing the first protective member 12 and second protective member 13 are chamfered. As a result, when the peripheral portions of the solar cell panel 10 are fitted into the fitting portion 22, scratching of the first protective member 12 and second protective member 13 of the solar cell panel 10 can be prevented, even when the front end of the open portion 22a makes accidental contact with the first protective member 12 or the second protective member 13.

Also, the radius of curvature of the curved surface formed as the machined surface 12c of the first protective member 12 is greater than that of the radius of curvature of the curved surface formed as the machined surface 13c of the second protective member 13. In other words, the height (c) of the machined surface 12c of the first protective member 12 is greater than the height (d) of the machined surface 13c of the second protective member 13. The distance between the upper surface portion 23 and the machined surface 12c of the first protective member 12 is different from the distance between the bottom surface portion 24 and the machined surface 13c of the second protective member 13. More specifically, in the present embodiment, the distance between the upper surface portion 23 and the machined surface 12c of the first protective member 12 is greater than the distance between the bottom surface portion 24 and the machined surface 13c of the second protective member 13.

The following is an explanation of the method used to mount the solar cell panel 10 in a frame 20 having this configuration. When the solar cell panel 10 is mounted in the frame 20, a sealing material 40 such as a fluid silicone resin or urethane resin is applied using a dispenser. The application of the sealing material is centered on the side surface portion 25 of the fitting portion 22. Then, as shown in FIG. 2 and FIG. 3, the frame 20 is fitted into the peripheral portions of the solar cell panel 10 with the light-receiving surface of the panel facing downward vertically, that is, with the upper surface portion 23 of the frame 20 on the bottom side in the vertical direction. Thus, the solar cell panel 10 is inserted into the fitting portion 22 of the frame 20 with the first protective member 12 on the bottom side in the vertical direction. In the present specification, "vertical" indicates the normal direction relative to the plane in which the solar cell panel 10 extends.

When the frame 20 is mounted on the solar cell panel 10, the upper surface portion 23 faces the first protective member 12, and the lower surface portion 24 faces the second protective member 13. In the present embodiment, the radius of curvature of the curved surface formed as the machined surface 12c of the first protective member 12 is greater than that of the curved surface formed as the machined surface 13c of the second protective member 13. In other words, the machined surface 12c of the first protective member 12 is chamfered so as to be larger than the machined surface 13c of the second protective member 13.

As a result, the larger machined surface 12c formed on the first protective member 12 is able to maintain a larger space between the machined surface 12c of the first protective member 12 and the corner portion where the side surface portion 25 and the lower surface portion 24 connect in the fitting portion 22 of the frame 20. This larger space is able to prevent chipping and cracking when the solar cell panel 10 is fitted into the frame 20.

Meanwhile, the smaller machined surface 13c of the second protective member 13 is able to reduce the size of the interface between the machined surface 13c and the sealing material 14, and make it less likely that the sealing material 14 will peel off from the second protective member 13. As a result, deterioration in performance can be prevented in the solar cell module 1 due to the penetration of moisture when the sealing material 14 peels off from the second protective member 13. When the frame 20 is mounted on the solar cell panel 10, the second protective member 13 is on the upper side in the vertical direction. When the solar cell panel 10 bends, the space between the open portion 22a and the solar cell panel 10 becomes wider than it is when the solar cell panel 10 is not bent. This makes contact between the open portion 22a and the second protective member 13 impossible.

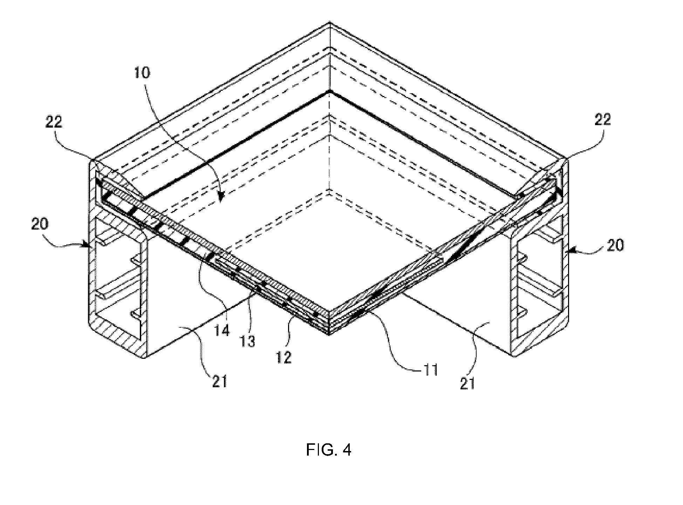

Thus, in the solar cell module according to the present invention, the peripheral surface portion of the solar cell panel 10 is sealed inside the fitting portion 22 using sealing material 40 without coming into contact with the open portion 22a, and is fixed to the frame 20 as shown in FIG. 1 and FIG. 4.

In the present embodiment, the thickness of the first and second protective members 12 and 13 are different, but glass plates with the same thickness can also be used. In this case, the amount of chamfering is increased in the protective member positioned on the bottom side in the vertical direction when the frame 20 is mounted on the solar cell panel 10 in order to maintain the proper spacing with the open portion 22a.

The embodiment disclosed herein is for illustrative purpose in every respect, and it should be understood that the embodiment does not impose any restrictions on the present invention.

For example, the type of solar cell in the present invention is not limited to the one in the present embodiment. The solar cell may have a substrate made of a crystalline semiconductor other than single-crystal silicon, such as polycrystalline silicon. A bifacial light-receiving solar cell may be used, or a monofacial light-receiving solar cell may be used. Also, a back contact solar cell may be used. The solar cell is not limited to a crystalline solar cell module, and may also be applied to a thin-film solar cell module.

In the explanation of the embodiment, the chamfered surfaces were curved surfaces made in the edges of the first protective member 12 and the second protective member 13. However, the present invention is not limited to this configuration. More specifically, the edges of the first protective member 12 and the second protective member 13 may be either chamfered surfaces or flat surfaces. When the machined surfaces are flat, the flat surface formed as the machined surface 12c of the first protective member 12 and the flat surface formed as the machined surface 13c of the second protective member 13 are different in size, and the size of the flat surface formed by machined surface 12c is larger than the flat surface formed by machined surface 13c.

Also, in the explanation of the embodiment, the frame 20 was attached to the solar cell panel 10 to form the solar cell module 1. However, the present invention is not limited to this method. More specifically, the invention of the present application can have a configuration in which the peripheral portion of the solar cell panel 10 is inserted into a recessed portion. The fitting portion 22 in the present embodiment is merely one example of a recessed portion. Therefore, the invention in the present application may be, for example, a photovoltaic power generating system in which the solar cell panel is gripped and secured by the recessed portion of a mounting cradle.

The scope of the present invention is defined by the scope of the claims and not by the description of an embodiment above, and includes everything equivalent in meaning to the scope of the claims and all modifications therein.

### Key to the Drawings

- 1:: Solar cell module
- 10:: Solar cell panel
- 11:: Solar cell
- 12:: First protective member
- 12c:: Machined surface
- 13:: Second protective member
- 13c:: Machined surface
- 20:: Frame
- 21:: Main portion
- 22:: Fitting portion
- 22a:: Open portion
- 23:: Upper surface portion
- 24:: Lower surface portion

## Claims

1. A solar cell module comprising a solar cell panel having a plurality of solar cells sealed between a first protective member and a second protective member, and a frame mounted on the periphery of the solar cell panel,
an edge of each of the first protective member and the second protective member having been chamfered, the surface of the first protective member formed by chamfering being different in size from the surface of the second protective member formed by chamfering.

2. The solar cell module according to claim 1, wherein, between the first protective member and the second protective member, the surface formed by chamfering the protective member positioned on the bottom side in the vertical direction is larger than the surface formed by chamfering of the other protective member when the solar cell panel is fitted into the frame.

3. The solar cell module according to claim 1 or claim 2, wherein, between the first protective member and the second protective member, the surface formed by chamfering the protective member on the light-receiving side is larger than the surface formed by chamfering the protective member on the back surface side.

4. The solar cell module according to any one of claims 1 through 3, wherein the first protective member and the second protective member are made of glass.

5. The solar cell module according to any one of claims 1 through 4, wherein the first protective member and the second protective member have different thicknesses.

6. The solar cell module according to claim 5, wherein, between the first protective member and the second protective member, the thickness of the protective member on the back surface side is smaller than the thickness of the protective member on the front surface side.

7. A method for manufacturing a solar cell module including a solar cell panel having a plurality of solar cells sealed between a first protective member and a second protective member, and a frame mounted on the periphery of the solar cell panel,
an edge of each of the first protective member and the second protective member having been chamfered, the surface of the first protective member formed by chamfering being different in size from the surface of the second protective member formed by chamfering, and the first protective member and the second protective member being positioned when the solar cell panel is fitted into the frame such that the protective member having the larger surface formed by chamfering is positioned on the bottom side in the vertical direction.

8. The method for manufacturing a solar cell module according to claim 7, wherein the first protective member and the second protective member are glass plates having different thicknesses, and, between the first protective member and the second protective member, the thickness of the protective member on the light-receiving side is greater.

9. A solar cell panel having a plurality of solar cells sealed between a first protective member and a second protective member, the periphery thereof being fitted into and secured inside a recessed portion,
an edge of each of the first protective member and the second protective member having been chamfered, and the surface of the first protective member formed by chamfering being different in size from the surface of the second protective member formed by chamfering.

10. The solar cell panel according to claim 9, wherein, between the first protective member and the second protective member, the surface formed by chamfering of the protective member positioned on the bottom side in the vertical direction is larger than the surface formed by chamfering of the other protective member when the solar cell panel is fitted into the recessed portion.

11. The solar cell panel according to claim 9 or claim 10, wherein, between the first protective member and the second protective member, the surface formed by chamfering of the protective member on the light-receiving side is larger than the surface formed by chamfering of the protective member on the back surface side.

12. The solar cell panel according to any one of claims 9 through 11, wherein the first protective member and the second protective member are made of glass.

13. The solar cell panel according to any one of claims 9 through 12, wherein the first protective member and the second protective member have different thicknesses.
